Europäisches Patentamt

European Patent Office

Office européen des brevets

(19)

(11) Veröffentlichungsnummer: **0 203 368**
**B1**

(12) # EUROPÄISCHE PATENTSCHRIFT

(45) Veröffentlichungstag der Patentschrift:
08.03.89

(21) Anmeldenummer: 86105597.8

(22) Anmeldetag: 23.04.86

(51) Int. Cl.⁴: **B 32 B 15/04,** C 25 D 7/06,
**B 32 B 31/04**

(54) **Verfahren und Vorrichtung zur Herstellung kupferkaschierter Laminate.**

(30) Priorität: 02.05.85 DE 3515629

(43) Veröffentlichungstag der Anmeldung:
03.12.86 Patentblatt 86/49

(45) Bekanntmachung des Hinweises auf die Patenterteilung:
08.03.89 Patentblatt 89/10

(84) Benannte Vertragsstaaten:
DE FR GB IT SE

(56) Entgegenhaltungen:
EP-A-0 120 192
DE-A-1 704 785
DE-A-3 212 152
US-A-4 399 183

(73) Patentinhaber: Held, Kurt, Alte Strasse 1, D-7218
Trossingen 2 (DE)

(72) Erfinder: Held, Kurt, Alte Strasse 1, D-7218
Trossingen 2 (DE)

EP 0 203 368 B1

## Beschreibung

Die Erfindung betrifft ein Verfahren zur kontinuierlichen Herstellung kupferkaschierter Laminate gemäß dem Oberbegriff des Patentanspruchs 1 und Vorrichtungen zur Durchführung dieses Verfahrens gemäß den Oberbegriffen der Patentansprüche 4 bis 6.

Solche kupferkaschierten Laminate, auch Elektrolaminate genannt, dienen als Ausgangsmaterial für Leiterplatten und bestehen aus einem Kern aus mehreren Lagen von isolierendem Material, das mit einem vorkondensierten Harz getränkt ist. Üblicherweise werden für diese Lagen mit Phenolharz getränkte Hartpapiere oder mit Epoxyharz getränkte Glasfasergewebe, das sogenannte Prepreg, verwendet. Auf einer oder beiden Oberflächen des Kerns befindet sich eine elektrolytisch abgeschiedene Kupferfolie von hohem Reinheitsgrad. Das Prepreg wird zusammen mit der Kupferfolie unter Wärmeeinwirkung zu dem Elektrolaminat verpreßt.

Die Ausgangsmaterialien zur Herstellung von Elektrolaminaten, das heißt die harzimprägnierten Kernlagen sowie die Kupferfolie sind bahnförmig auf Rollen verfügbar. Die Herstellung der elektrolytisch abgeschiedenen Kupferfolien erfolgt mit Hilfe einer Trommel aus Edelstahl, die mit einem Teil der Oberfläche in ein Bad taucht, das Kupferionen in Lösung enthält. Im Bad befindet sich eine der Trommel gegenüberliegende Anode. Die Trommel wird als Kathode geschaltet. Auf dem im Bad befindlichen Teil der Trommeloberfläche scheiden sich dann Kupferionen aufgrund des zwischen Anode und Kathode befindlichen elektrischen Feldes ab. Von der gleichmäßig rotierenden Trommel kann die Kupferfolie kontinuierlich abgezogen und aufgewickelt werden (siehe G. Leonida, Handbook of printed circuit design, manufacture, components & assembly, erschienen in Electrochemical Publications Limited, 1981).

Bei der kontinuierlichen Herstellung von Elektrolaminaten werden solchermaßen hergestellte Kupferfolien und die harzimprägnierten Schichtstoffbahnen für den Kern von Vorratsrollen in Abwickeleinheiten kontinuierlich abgewickelt, dem Aufbau des Elektrolaminats entsprechend mit gleicher Geschwindigkeit zu einem Schichtgebilde zusammengeführt und dieses Schichtgebilde anschließend in der zwischen den beiden Preßbändern einer Doppelbandpresse liegenden Reaktionszone unter Einwirkung von Hitze und Druck zu der Elektrolaminatbahn verpreßt. Die Elektrolaminatbahn verläßt in Vorlaufrichtung der Preßbänder hinter der Reaktionszone die Doppelbandpresse und wird danach in einer Vorratsrolle aufgewickelt, falls es sich um eine flexible Elektrolaminatbahn handelt oder in einzelne Platten beliebiger Größe aufgeteilt. Diesen Stand der Technik kennzeichnet die Druckschrift EP-A-0 120 192.

Nachteilig bei diesem bekannten Verfahren ist die Zweistufigkeit und der damit verbundene zusätzliche Handhabungsaufwand. Die Kupferfolien werden wie geschildert elektrolytisch abgeschieden, anschließend aufgerollt und zwischengelagert bis sie mit harzimprägnierten Schichtstoffbahnen verpreßt werden. Dabei ist es unumgänglich, daß sich während der Lagerung und insbesondere auch beim Abwickeln der Kupferfolie vor der Doppelbandpresse durch elektrostatische Anziehung Staubpartikel auf der Oberfläche der Kupferfolie absetzen. Besonders die Staubpartikel die sich auf der Oberfläche der Kupferfolie befinden, die dem Schichtstoffkern abgewandt ist, führen zu minderwertigen Elektrolaminaten, indem sie beim Verpressen in die Oberfläche der Kupferfolie eingedrückt werden und dort zu Fehlstellen führen. Zwar werden bei dem Verfahren in genannter Druckschrift vor der Doppelbandpresse Abstreifer angeordnet, die den Staub vor Einlauf in die Doppelbandpresse entfernen sollen, jedoch hat es sich gezeigt, daß es mit dieser Maßnahme nicht gelingt, sämtlichen anhaftenden Staub zu entfernen.

Ein weiterer diesem Verfahren anhaftender Nachteil ist darin zu sehen, daß es das Verpressen von ultradünnen Kupferfolien, das sind Kupferfolien mit einer Dicke von weniger als 10 Mikrometern, nicht gestattet. Solche ultradünnen Kupferfolien sind nur sehr schwer zu handhaben, da sie extrem empfindlich und bei der kontinuierlichen Abwicklung von der Rolle stark rißgefährdet sind. Außerdem wirken sich hier Staubablagerungen auf der Kupferfolienoberfläche noch viel gravierender aus. Andrerseits ist die Verwendung solcher ultradünner Kupferfolien an und für sich wünschenswert, da bei der Weiterverarbeitung des Elektrolaminats zu Leiterplatten sowohl die Ätzzeit wie auch der Materialverbrauch wesentlich verringert wird. Bei Herstellung von Feinstleiterbahnen mit einer großer Leiterbahndichte ist aufgrund der Unterätzung der Leiterbahnen keine dicke Kupferfolie verwendbar und der Einsatz von ultradünnen Folien daher unumgänglich.

Eine weitere Schwierigkeit, die besonders bei der Verwendung von ultradünnen Kupferfolien auftritt, besteht darin, daß eine Bildung von Falten durch unterbundene Wärmedehnung der Folie bei der Verpressung nur schwer zu verhindern ist. Ebenso ist das Vorhandensein feinster Poren in der Kupferfolie kaum zu vermeiden. Diese Mikroporen gestatten ein Durchfließen des geschmolzenen Epoxyharzes beim Verpressen auf die Preßbandoberfläche. Das ausfließende Harz breitet sich dann in der Fuge zwischen der Kupferfolie und dem Preßband aus und deckt die Kupferfolie beim fertigen Elektrolaminat gegen die Einwirkung von Ätzmitteln ab, was somit noch wesentlich größere Fehl stellen als die Pore allein verursacht.

Zumindestens beim Verpressen von Schichtstoffen mit ultradünner Kupferfolie in diskontinuierlichen Ein- oder Mehretagenpressen zu einer Elektrolaminattafel ist es bekannt, diese ultradünnen Folien bei der elektrolytischen Herstellung auf einem Träger, der beispielsweise aus einer Aluminiumbahn besteht, abzuscheiden (siehe DE-AS 24 13 669). Die ultradünne Kupferfolie wird anschließend zusammen mit dem Träger und den Schichtstoffen verpreßt. Nach dem Verpressen wird der Träger von der Kupferfolienoberfläche wieder abgezogen. Nachteilig ist bei diesem Verfahren, daß zusätzlich ein teurer Träger gebraucht wird, der nach dem Verpressen als Abfall nicht weiter verwendet werden kann.

Ein weiteres, davon unterschiedliches Verfahren zur Herstellung eines dünnen, kupferbeschichteten Verbundelementes ist aus der DE-A-2 839 481 bekannt geworden. Bei diesem Verfahren wird ein endlos umlaufendes Band durch eine Elektroplattiervorrichtung hindurchgeführt, so daß sich auf dem Band eine dünne Kupferfolie abscheidet, deren freie Oberfläche anschließend zur Haftungsverbesserung weiter behandelt werden kann. Danach läuft das Band mit der aufliegenden Kupferfolie an einer Beschichtungseinrichtung vorbei, wo die freie, dem Band abgewandte Oberfläche der Kupferfolie mit Harzpulver versehen wird, das anschließend mittels einer Heizvorrichtung zum Schmelzen gebracht wird. Dabei wachsen die Kunststoffteilchen zusammen und verbinden sich mit der Kupferfolienoberfläche. Falls gewünscht, kann anschließend noch eine weitere Verdichtung der Kunststoffschicht mittels Kalanderwalzen erfolgen. Danach wird das Verbundelement vom Band getrennt und das Band läuft wieder zur Elektroplattiervorrichtung zurück.

Das endlos umlaufende Band dient hier als Trägerband zur Abscheidung einer Kupferfolie, mit dem jedenfalls kein Druck bei der Herstellung des Verbundwerkstoffes ausgeübt wird. Der Kunststoff wird durch Wärmeeinwirkung und im wesentlichen drucklos mit der Kupferfolie verbunden. Soweit Kalanderwalzen erwähnt werden, üben diese nur einen kurzfristigen, linienförmigen Druck aus, der auch erst nach Beendigung der Erwärmung auf den Kunststoff einwirkt. Zumindestens bei der Verwendung von duroplastischen Harzen ist der Kunststoff des nach diesem Verfahren hergestellten Verbundelements porös und besitzt eine nur geringe Haftung auf der Kupferfolie, so daß ein Verbundelement von geringer Qualität entsteht. Für die Herstellung von qualitativ hochwertigen kupferkaschierten Laminaten, deren Kern aus mit duroplastischen Harzen imprägnierten Schichtstoffbahnen besteht, läßt sich das aus der Druckschrift bekannte Verfahren daher nicht einsetzen.

In der US-A-4 399 183 wird die Herstellung einer Ionenaustauschermembran beschrieben, bei der ein Schichtgebilde aus zwei Filmen mit einem dazwischenliegenden Verstärkungsgewebe zwischen je zwei Bändern, die am Rand des Schichtgebildes angreifen, geführt wird. Diese Bänder sind über Umlenktrommeln in einem Gestell geführt und verlaufen in vertikaler Richtung aufwärts. Auf die Rückseiten der Bänder wirkt von einer Seite eine anliegende Platte ein und auf die andere Seite des Bandes eine Vakuumplatte.

In der DE-A-3 212 152 ist eine Vorrichtung zum selektiven galvanischen Beschichten eines Metallbandes gezeigt. Diese Vorrichtung besitzt einen Elektrolyt-Auffangbehälter, durch das ein über zwei Umlenkwalzen geführtes, endloses Trägerband hindurchläuft. Entlang des Trägerbandes laufen ein oder mehrere, ebenfalls über Umlenktrommeln geführte Maskenbänder endlos durch den Elektrolyt-Auffangbehälter hindurch. Die Breitseiten sowohl des Trägerbandes als auch der Maskenbänder zeigen in vertikaler Richtung. Das zu beschichtende Metallband wird von einer Vorratsspule abgewickelt und zwischen dem Trägerband und den Maskenbändern durch den Elektrolyt-Auffangbehälter hindurchgeführt. Im Elektrolyt-Auffangbehälter wird die Elektrolytflüssigkeit auf das zu beschichtende Metallband gesprüht.

Sowohl in der US-A-4 399 183 als auch in der DE-A-3 212 152 handelt es sich nicht um die druckausübenden Preßbänder einer Doppelbandpresse, sondern eher um Förderbänder, die Materialbahnen durch eine Bearbeitungsvorrichtung hindurchführen. In diesen Vorrichtungen werden auch keine kupferkaschierten Elektrolaminate hergestellt, so daß diese Druckschriften dem Fachmann für die Ausgestaltung einer zur Herstellung von Elektrolaminaten geeigneten Doppelbandpresse keine Anregung geben können.

Ausgehend von diesem Stand der Technik liegt der vorliegenden Erfindung die Aufgabe zugrunde, das kontinuierliche, mit Flächenpressung arbeitende Verfahren der eingangs genannten EP-A-0 120 192 so zu verbessern, daß bei der Herstellung qualitativ hochwertiger kupferkaschierter Laminate eine Zwischenlagerung der empfindlichen Kupferfolie vermieden wird, die Gefahr von Fehlstellen durch Staub, Falten- oder Porenbildung auf der Kupferfolie des kupferkaschierten Laminats sehr stark verringert ist und bei dem auch eine Verwendung von ultradünnen Kupferfolien ohne den sonst üblichen, teuren Träger möglich ist.

Die Lösung dieser Aufgabe wird durch die im Kennzeichen des Patentanspruchs 1 beschriebene technische Lehre vermittelt und zur Durchführung dieses Verfahrens dienende Vorrichtungen werden im Kennzeichen der Patentansprüche 4 bis 6 angegeben.

Die mit der Erfindung erzielbaren Vorteile bestehen insbesondere darin, daß das kontinuierliche Verfahren nicht mehr zweistufig, sondern einstufig abläuft. Damit erübrigt sich eine Zwischenlagerung und zusätzliche Handhabung der Kupferfolie und die dadurch bedingten Beschädigungsgefahren der Kupferfolie entfallen. Da die am fertigen Elektrolaminat außenliegende Oberfläche der Kupferfolie bis nach der Verpressung ständig vom Preßband bedeckt ist, können sich auf dieser Oberfläche keine Staubpartikel absetzen, womit die Gefahr von Fehlstellen im Elektrolaminat gebannt ist. Durch die direkte Abscheidung der Kupferfolie auf dem Preßband erhält diese schon bei der Abscheidung die Temperatur des Preßbandes, womit Faltenbildungen vermieden werden. Bei der vorteilhaften Verwendung der Tampon-Galvanisiermethode ist durch die ständige Reibbeanspruchung der sich abscheidenden Folienoberfläche die Gefahr von Mikroporen in der Kupferfolie völlig eliminiert. Die dünne Kupferfolie wird vor der Verpressung ständig vom Preßband getragen, womit die Notwendigkeit eines zusätzlichen, teuren Trägers für eine ultradünne Kupferfolie völlig entfällt. Das erfindungsgemäße Verfahren steigert die Qualität des Erzeugnisses und verringert entscheidend dessen Kosten.

Eine bevorzugte Ausführungsform zur Durchführung des erfindungsgemässen Verfahrens ist in den Zeichnungen dargestellt und wird im folgenden näher beschrieben. Es zeigen

Fig. 1 eine Vorrichtung zur Abscheidung der Kupferfolie und Verpressung zum Elektrolaminat,

Fig. 2 eine Vorrichtung entsprechend Fig. 1 mit vertauschten Ein- und Auslauf der Doppelbandpresse,

Fig. 3 eine Vorrichtung zur Durchführung des Verfahrens, die aus einer hochkant gestellten Doppelbandpresse besteht und

Fig. 4 einen vergrösserten Teilausschnitt aus Fig. 1 zur Übertragung der Spannung auf das Pressband mittels Quecksilber.

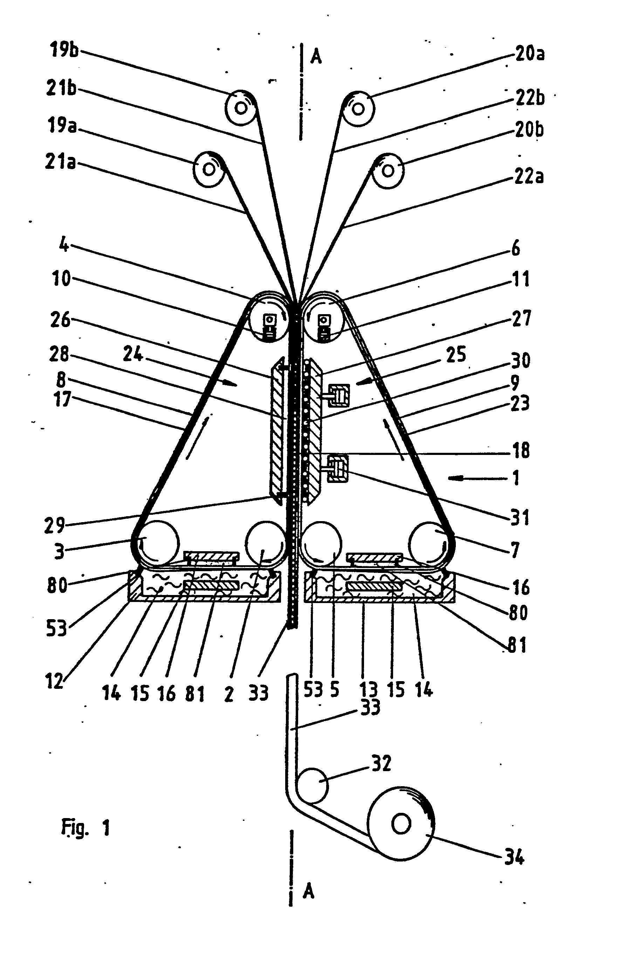

Bei der in Fig. 1 gezeigten Vorrichtung handelt es sich um eine vertikal aufgestellte Doppelbandpresse, so dass deren Längsachse vertikal steht. Diese Doppelbandpresse 1 besitzt jedoch im Gegensatz zu einer herkömmlichen Doppelbandpresse nicht vier sondern sechs Umlenktrommeln 2, 3, 4, 5, 6, 7. Jeweils drei dieser Umlenktrommeln 2, 3, 4 sind so angeordnet, dass sie an den Ecken eines rechtwinkligen Dreiecks sitzen, wobei der rechte Winkel sich bei der Umlenktrommel 2 befindet. Über diese drei Umlenktrommeln ist ein Pressband 8 gespannt, das aus einem hochzugfesten Edelstahl besteht. Diese Anordnung wiederholt sich spiegelbildlich zu einer Linie A-A entlang der vertikalen Kathete des Dreiecks, wobei diese Anordnung aus den Umlenktrommeln 5, 6, 7 und dem Pressband 9 besteht. Die Pressbänder 8 und 9 werden mittels Hydraulikzylinder 10 und 11, die an den Umlenktrommeln 4 bzw. 6 befestigt sind, gespannt.

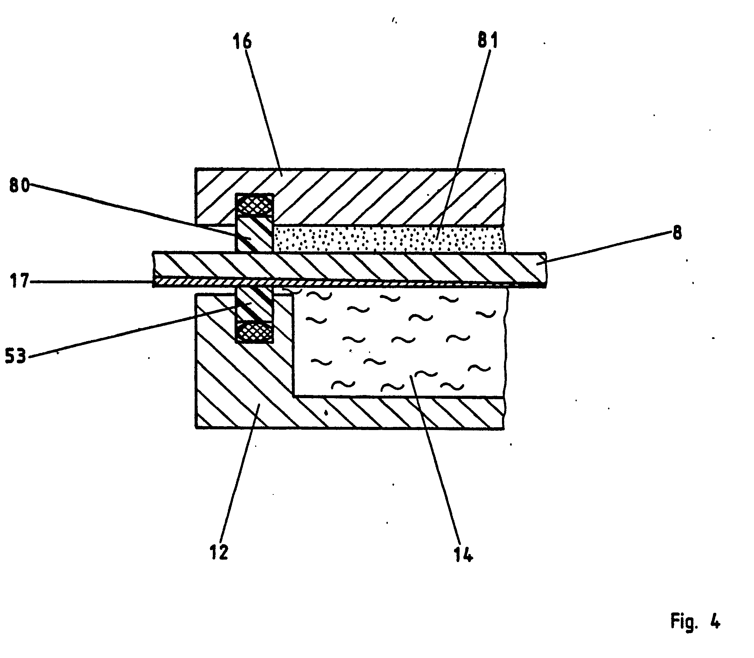

Die Umlenktrommeln drehen sich entsprechend der in Fig. 1 eingezeichneten pfeile, so dass die Pressbänder sich entsprechend der Pfeilrichtung bewegen. Unterhalb der horizontalen Kathete des rechtwinkligen Dreiecks ist eine Wanne 12 so angeordnet, dass sie sich entlang des zwischen den Umlenktrommeln 2 und 3 gespannten Pressbandes erstreckt. Die Wanne 12 ist mit einem Elektrolyten 14 gefüllt, der aus einer Kupfersulfatlösung besteht. Die Wanne 12 ist dabei soweit gefüllt, dass die aüssere Oberfläche des Pressbandes 8 mit dem Elektrolyten 14 bedeckt wird. In dieser Wanne befindet sich eine Platte 15, die in einem zweckmässigen Abstand dem Teil der Aussenfläche des pressbandes, das in die Wanne 12 eintaucht, gegenüberliegt. Diese Platte 15 besitzt dieselbe Breite wie das Pressband 8 und vorzugsweise eine Länge, die dem kleinsten Abstand zweier Peripheriepunkte der beiden Umlenktrommeln 2 und 3 entspricht. Auf der inneren Oberfläche des Pressbandes 8, der Platte 15 gegenüberliegend, liegt eine weitere Platte 16, die dieselbe Grösse wie die Platte 15 besitzt. Die Platte 16 besitzt zum Pressband 8 einen geringen Abstand. In diesem Raum zwischen der Platte 16 und der Innenfläche des Pressbandes 8 befindet sich ein flüssiges Metall 81, beispielsweise Quecksilber (siehe auch Fig. 4). Die Ränder der Platte 16 sind mit an der Pressbandinnenfläche anliegenden Gleitdichtungen 80 ausgestattet, so dass das flüssige Metall nicht aus diesem Zwischenraum austreten kann.

Die Platten 15 und 16 bestehen aus Blei. Die in der Wanne 12 befindliche Platte 15 ist über eine Leitung mit genügend grossem Querschnitt mit dem positiven Pol einer Gleichspannungsquelle verbunden, so dass sie als Anode wirkt. Die auf der Innenfläche des Pressbandes angebrachte Platte 16 ist mit dem negativen Pol derselben Gleichspannungsquelle verbunden, so dass derjenige Teil des Pressbandes 8, der an der Platte 16 entlanggleitet und über das aus Quecksilber bestehende flüssige Metall 81 mit der Platte 16 elektrischen Kontakt besitzt, als Kathode wirkt. Gemäss dem bekannten galvanischen Prinzip scheiden sich aus dem Elektrolyten 14 in der Wanne 12 nun Kupferatome auf der der Anode 15 gegenüberliegenden Stelle der Aussenfläche des als Kathode wirkenden Pressbandes 8 ab. Da das Pressband 8 sich kontinuierlich in Pfeilrichtung vorwärtsbewegt, nimmt die Schichtdicke der Kupferschicht auf der Bandoberfläche während des Durchlaufs durch die Wanne 12 zu und die Schichtdicke erreicht ihren maximalen Wert an der Umlenktrommel 3 beim Verlassen der Wanne 12. Entsprechend dem erfindungsgemässen Verfahren wird die direkt auf dem Pressband galvanisch abgeschiedene Kupferfolie 17 dann mit dem Pressband in Richtung Reaktionszone 18 der Doppelbandpresse transportiert.

Die Dimensionierung der Gleichspannungsquelle, die üblicherweise durch einen Netztransformator mit anschliessendem Gleichrichter dargestellt wird, erfolgt nach den bekannten Gesetzen der Elektrolyse. Um eine gleichmässige Kupferschicht abzuscheiden, wird die Temperatur des Elektrolyten in der Wanne 12 mittels in der Wanne angebrachter Temperaturfühler ständig kontrolliert und durch Zufuhr von entsprechend temperiertem Elektrolyten konstant gehalten. Durch Zufuhr mit frischem Elektrolyten wird gleichzeitig der verbrauchte Elektrolyt ersetzt, da durch die die Abscheidung der Kupferionen auf der Bandoberfläche dessen Konzentration entsprechend abnimmt. Somit ist sowohl die Temperatur wie auch die Konzentration des Elektrolyten über den gesamten Abscheidungszeitraum konstant. Da durch die plattenförmige Ausbildung von Anode und Kathode die Stromdichte im Elektrolysebad ebenfalls weitgehend konstant ist, gelingt insgesamt die Abscheidung einer gleichmässig dicken, homogenen Kupferfolie auf der Oberfläche des Bandes 8, die den hohen qualitativen Anforderungen, die an Elektrolaminate gestellt werden, genügt.

Um die Konzentration der Kupferionen im Elektrolyten automatisch konstant zu halten, besteht auch die Möglichkeit, die Platte 15, die die Anode darstellt, aus Kupfer zu fertigen und als Elektrolytflüssigkeit eine saure Kupfersulfatlösung zu verwenden. Während des Elektrolysevorganges gehen dann soviele Kupferionen von der Anode in Lösung, wie Kupferionen aus dem Elektrolyten an der Bandoberfläche reduziert werden und sich dort abscheiden. Dabei wird selbstverständlich die Anode verbraucht und ist von Zeit zu Zeit durch eine neue Kupferplatte zu ersetzen.

Um die Verlustleistungen so gering wie möglich zu machen, müssen die Zuleitungen des Stromes zur Anode und Kathode mit geringstmöglichem Widerstand erfolgen. Es werden daher wie in der Galvanik üblich Leitungen aus einem Material mit kleinem elektrischen Widerstand, beispielsweise Kupfer mit entsprechend grossem Querschnitt, verwendet. Diese Leitungen sind in Fig. 1 aus Übersichtlichkeitsgründen nicht eingezeichnet.

Das Pressband 8 mit der auf seiner Oberfläche aufgalvanisierten Kupferfolie 17 bewegt sich mit gleichförmiger Geschwindigkeit und verlässt bei der Umlenktrommel 3 das in der Wanne 12 befindliche Elektrolytbad. Mit dem Pressband 8 wird die Kupferfolie 17 zu der Umlenktrommel 4 weitertransportiert. Auf dieser Strecke zwischen den zwei Umlenktrommeln 3 und 4 kann eine Behandlung der nun obenliegenden Oberfläche zur besseren Haftung der Kupferfolie 17 auf der Kernschicht erfolgen. Eine solche zum Stande der Technik gehörende Behandlung kann beispielsweise eine Anätzung der Kupferfolienoberfläche sein oder die Abscheidung von stark knospenbildenden Messingauflagen auf der dem Pressband gegenüberliegenden Kupferfolienoberfläche.

An der Umlenktrommel 4 wird die auf dem Pressband 8 aufliegende Kupferfolie 17 so umgelenkt, dass sie sich nun in die Reaktionszone 18 der Doppelbandpresse 1 bewegt. Zusammen mit der Kupferfolie werden Bahnen 21a, 21b, 22a, 22b, die aus mit Epoxyharz imprägniertem Glasfasergewebe bestehen, in die Reaktionszone 18 mit eingeführt. Diese Glasfaserbahnen bilden den Kern des Elektrolaminats und werden von Abwickeleinheiten 19a, 19b, 20a, 20b, die sich in der Nähe der Umlenktrommeln 4 und 6 befinden, kontinuierlich abgezogen. In diesem Ausführungsbeispiel wird der Kern des Elektrolaminats von vier Lagen von Glasfaserbahnen gebildet. Es können jedoch je nach gewünschter Dicke und Stabilität des Elektrolaminats mehr oder auch weniger Glasfaserbahnen verwendet werden. Falls es zweckmässig erscheint, können sich auch sämtliche Abwickeleinheiten bei der Umlenktrommel 4 oder 6 befinden bzw. die Aufteilung der Abwickeleinheiten zu den einzelnen Umlenktrommeln kann nach dem vorhandenen Platz erfolgen. Sowohl die Kupferfolien, Glasfaserbahnen als auch das Elektrolaminat sind aus Darstellungsgründen im Verhältnis zur Doppelbandpresse übertrieben dick eingezeichnet.

Soll das Elektrolaminat beidseitig mit Kupferfolie kaschiert werden, so wird bei der zweiten Pressbandhälfte 25, bestehend aus den Umlenktrommeln 5, 6, 7 und dem Pressband 9, an der Unterseite entlang den Umlenktrommeln 5 und 7 ebenfalls eine Wanne 13 montiert. Diese Wanne 13 enthält analog zu der Wanne 12 eine Elektrolytflüssigkeit 14 und eine Anode 15. Auf der Innenseite des Pressbandes 9 befindet sich gegenüber der Anode ebenfalls eine Kathode 16, wobei die Stromzufuhr wie weiter oben erläutert über flüssiges Quecksilber erfolgt, so dass sich auf dem Pressband 9 eine Kupferfolie 23 abscheidet. Diese Kupferfolie 23 wird mit dem Pressband 9 zur Umlenktrommel 6 transportiert und dort in die Reaktionszone 18 umgelenkt. Selbstverständlich kann bei einer einseitigen Kaschierung des Elektrolaminats mit einer Kupferfolie dieselbe auch anstatt auf der Pressbandeinheit 24 auf der Pressbandeinheit 25 wie beschrieben abgeschieden werden.

In der Reaktionszone 18 befindet sich auf dem Pressband 8 die Kupferfolie 17, an deren dem Pressband 8 abgewandten Oberfläche liegt die imprägnierte Glasfaserbahn 21a an. An diese Glasfaserbahn 21a sind wiederum die übrigen Glasfaserbahnen in der Reihenfolge 21b, 22b und 22a geschichtet. Falls es sich um ein einseitig kaschiertes Elektrolaminat handelt, liegt die zweite Oberfläche der Bahn 22a an dem Pressband 9 an. In Fig. 1 ist ein zweiseitig kaschiertes Elektrolaminat gezeigt, so dass die Bahn 22a an der Oberfläche der Kupferfolie 23 anliegt. Mit der zweiten Oberfläche liegt diese Kupferfolie 23, wie bereits beschrieben, auf dem Pressband 9 auf. Zu bemerken ist besonders, dass falls eine Oberflächenbehandlung zur Haftverbesserung der Kupferfolie auf dem Glasfaserkern stattgefunden hat, die behandelte Oberfläche nun auf der jeweiligen Glasfaserbahn 21a bzw. 22a aufliegt.

Auf diese entsprechend der Beschreibung geschichtete Werkstoffbahn wird in der Reaktionszone 18 Druck ausgeübt. Dieser Druck wird über Druckplatten 26, 27 hydraulisch oder mechanisch auf die Innenseiten der Pressbänder 8, 9, d.h. die Seiten der Pressbänder die der Kupferfolie 17, 23 abgewandt sind, aufgebracht und von dort auf die Werkstoffbahn übertragen. Bei der hydraulischen Druckübertragung wird in dem Raum 28, der zu den Seiten von der Druckplatte 26 und der Innenseite des Pressbandes 8 und nach oben und unten von der Dichtung 29 begrenzt wird, ein unter Druck setzbares, fluides Druckmedium, beispielsweise Öl oder Luft, eingebracht. Zur mechanischen Druckübertragung sind zwischen der Druckplatte 27 und der Innenseite des Pressbandes 9 ortsfeste Rollen 30 angebracht. Mit Hilfe von Hydraulikzylindern 31 werden die Druckplatte 27 und damit die Rollen 30 gegen die Innenseite des Pressbandes 9 angestellt. Das Pressengestell, das die von der Werkstoffbahn ausgehenden Reaktionskräfte aufnimmt und in dem sowohl die Druckplatten 26, 27 als auch beide Pressbandeinheiten 24, 25 gelagert sind, ist in der Zeichnung der Übersichtlichkeit halber weggelassen.

Durch den auf die Werkstoffbahn in der Reaktionszone 18 ausgeübten Druck und gegebenenfalls unter zusätzlichem Einsatz von Wärme wird das Epoxyharz ausgehärtet, während sich die Werkstoffbahn kontinuierlich durch die Reaktionszone 18 hindurchbewegt und die Glasfaserbahnen 21a, 21b, 22b, 22a werden sowohl untereinander als auch mit den anliegenden Kupferfolien 17, 23 zu einer festen Einheit, dem sogenannten Elektrolaminat, verbunden. Falls es erforderlich ist, kann die Reaktionszone in eine am Einlauf in die Doppelbandpresse bei den Umlenktrommeln 4 und 6 beginnende Heizzone und in eine Kühlzone eingeteilt sein, die am Auslauf bei den Umlenktrommeln 2 und 5 endet. Damit kann die Werkstoffbahn nach Aushärten des Harzes unter Druck gekühlt werden, was die Qualität des Elektrolaminats weiter verbessert.

Am Auslauf aus der Doppelbandpresse, bei den Umlenktrommeln 2 und 5, werden die Pressbänder 8 und 9 wieder umgelenkt und laufen in die Wannen 12 und 13 des Elektrolytbades ein, wo sie erneut mit einer Kupferfolie beschichtet werden. Dabei trennt sich das nun ausgehärtete Elektrolaminat, dessen Oberfläche aus den Kupferfolien 17 und 23 besteht von den jeweiligen Pressbändern 8 und 9. Diese Trennung bereitet in der Regel keine Schwierigkeiten, da das auf die aus Edelstahl bestehenden Pressbänder aufgalvanisierte Kupfer schlecht auf der Pressbandoberfläche haftet und insbesondere keinen Verbund mit dieser Oberfläche eingeht.

Nachdem die Elektrolaminatbahn 33 die Doppelbandpresse verlassen hat, wird sie durch eine mitlaufende Quersäge, die in Fig. 1 nicht eingezeichnet ist, in einzelne Platten entsprechend den Anforderungen aufgeteilt. Diese kupferkaschierten Platten können in Paletten zum Abtransport gestapelt werden. Alternativ kann, falls es sich um ein flexibles Elektrolaminat handelt, die Elektrolaminatbahn 33 mit einer Umlenkrolle 32 umgelenkt und in einer Aufwickeleinheit 34 zu einer Rolle aufgewicket werden.

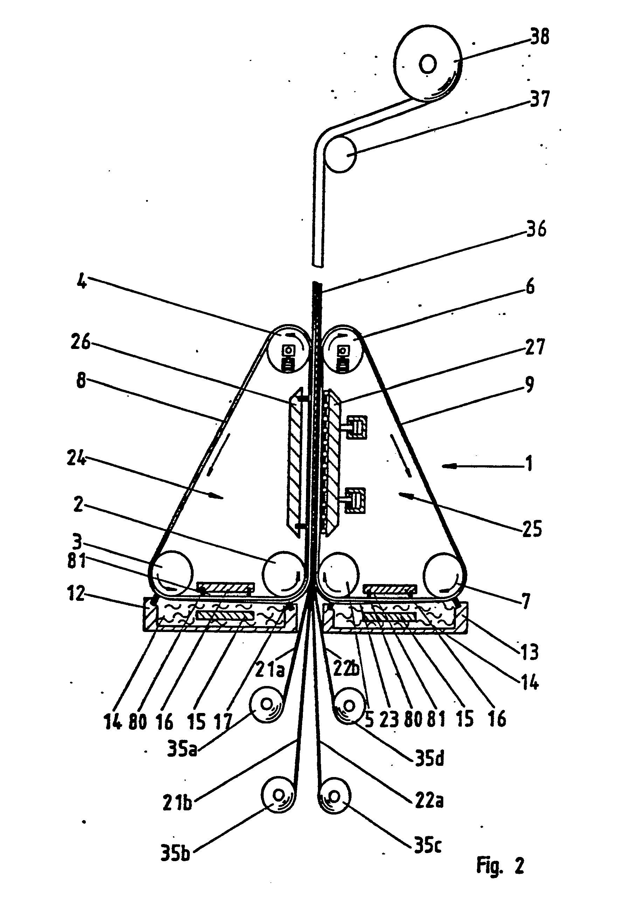

Eine Vorrichtung zur Durchführung des erfindungsgemässen Verfahrens, die entsprechend der Fig. 1 und der obigen Beschreibung arbeitet, bei der jedoch Aus- und Einlauf vertauscht sind, zeigt die Fig. 2. Die Pressbänder 8 und 9 bewegen sich nun in entgegengesetzter Richtung entsprechend den Pfeilen. Die Kupferfolien 17 und 23 erreichen ihre maximalen Dicken bei Verlassen des Elektrolytbades bei den Umlenktrommeln 2 und 5. Die mit Harz imprägnierten Glasfaserbahnen werden nun von Abwickelrollen 35a, 35b, 35c, 35d, die sich in der Nähe der Umlenktrommeln 2 und 5 befinden abgewickelt, laufen nun in den Einlauf der Doppelbandpresse bei den Umlenktrommeln 2 und 5 ein und werden in der Reaktionszone 18 mit den Kupferfolien 17 und 23 verpresst. Die Elektrolaminatbahn 36 verlässt am oberen Ende bei den Umlenktrommeln 4 und 6 die Doppelbandpresse und wird, falls es sich um ein flexibles Elektrolaminat handelt, mit der Umlenkrolle 37 so umgelenkt, dass es in der Aufwickeleinheit 38 auf eine Rolle aufgewickelt werden kann. Alternativ kann die Elektrolaminatbahn 36 hinter den Umlenktrommeln 4 und 6 gleich in Platten der gewünschten Grösse geschnitten werden.

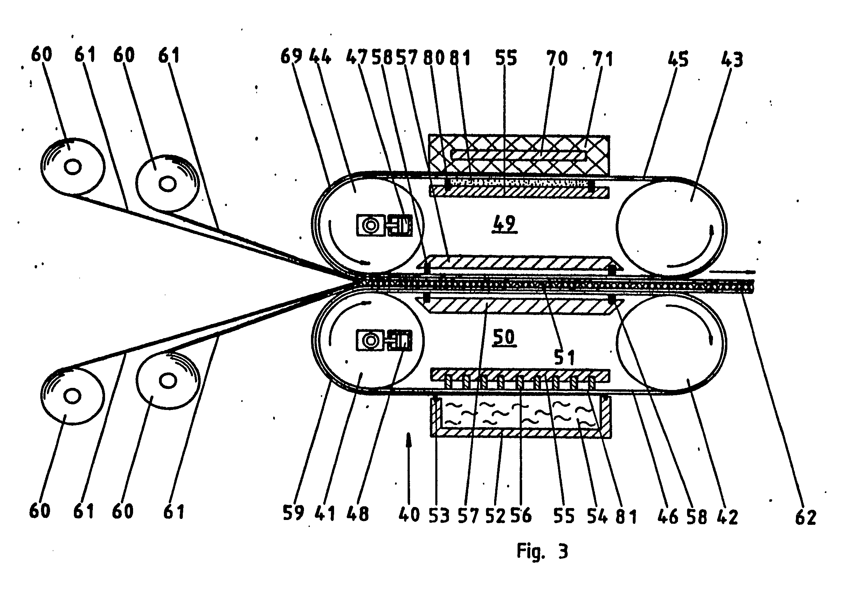

Eine weiteres Ausführungsbeispiel zur Durchführung des erfindungsgemässen Verfahrens ist in Fig. 3 zu sehen. Dort wird, im Schnitt entlang einer horizontalen Ebene, eine gewöhnliche Doppelbandpresse gezeigt, wie sie zur Herstellung dekorativer Laminate verwendet wird. Diese Doppelbandpresse ist jedoch zusammen mit den Abwickel- und Aufwickeleinheiten um 90 Grad zu einer Längsachse gedreht aufgestellt, so dass die Breitseite der Pressbänder nun vertikal steht, d.h. die Doppelbandpresse steht hochkant.

Diese Doppelbandpresse 40 besitzt zwei nebeneinanderliegende Pressbandeinheiten 49, 50, in denen je zwei Umlenktrommeln 41, 42 bzw. 43, 44 gelagert sind. Um jeweils zwei dieser Umlenktrommeln ist ein endloses Pressband 45, 46 gespannt, das wiederum aus einem hochzugfesten Edelstahl besteht. Die Spannung der Pressbänder 45, 46 wird durch Hydraulikzylinder 47, 48, die an den Umlenktrommeln 41, 44 befestigt sind,

aufgebracht. Die Umlenktrommeln bewegen sich entsprechen den eingezeichneten Pfeilen, so dass die beiden Pressbänder 45, 46 sich gegensinnig bewegen.

Zwischen den zwei Pressbändern 45, 46 wird die in der Zeichnung von links nach rechts vorlaufende Werkstoffbahn unter gleichzeitiger Anwendung von Druck und Wärme verpresst. In dieser Reaktionszone 51 wird der ausgeübte Druck über Druckplatten 57 hydraulisch oder mechanisch auf die Innenseiten der Pressbänder 45, 46 aufgebracht und von dort auf die Werkstoffbahn übertragen. In Fig. 3 ist nur die hydraulische Druckübertragung.gezeigt, bei der in den Raum zwischen der Druckplatte 57 und der Pressbandinnenseite, der zu den Seiten durch Dichtungen 58 begrenzt ist, ein unter Druck setzbares Fluid eingebracht wird.

An der der Reaktionszone 51 abgewandten Seite der Pressbandeinheit 50 befindet sich an der Aussenfläche des Pressbandes 46 eine Wanne 52, deren Höhe die gesamte Breitseite des Pressbandes umfasst. Diese Wanne 52 ist an den Rändern mit Dichtungen 53 ausgestattet, die am Pressband 46 gleitend anlegen. In der Wanne 52 befindet sich die Elektrolytflüssigkeit 54, die wiederum aus einer Kupfersulfatlösung besteht. Die Wanne 52 wird weiter mit Unterdruck beaufschlagt, so dass bei Bewegung des Pressbandes 46 unterstützt durch die Dichtungen 53 keine Elektrolytflüssigkeit aus der Wanne austritt. Auf der Innenseite des Pressbandes 46, der Wanne 52 gegenüberliegend ist eine Stützplatte 55 im Pressengestell mit vorzugsweise derselben Grösse wie die Wanne 52 angebracht In dieser Stützplatte 55 und mit ihr leitend verbunden befinden sich nebeneinanderliegende Gleitleisten 56, deren Länge so gross wie die Breitseite des Pressbandes ist. Die Gleitleisten 56 bestehen aus einem Metall und berühren das Pressband 46 gleitend.

Die Stützplatte 55 wird mit dem negativen Pol der Gleichspannungsquelle verbunden, so dass über die Gleitleisten 56 der in dem Elektrolyten 54 befindliche Teil des Pressbandes 46 als Kathode wirkt. Die Wanne 52 ist aus einem gut leitfähigen Metall hergestellt und wird mit dem Pluspol der Gleichspannungsquelle verbunden, womit die Wanne 52 selbst als Anode geschaltet ist. Damit scheidet sich auf dem im Elektrolyten befindlichen Pressbandtrum, das kontinuierlich durch die Wanne 52 bewegt wird, eine aus Kupfer bestehende Folie 59 ab, deren maximale Dicke erreicht ist, wenn das Pressbandtrum die in der Zeichnung links liegende Begrenzung der Wanne 52 erreicht hat. Die an dem Pressband 46 anliegende Kupferfolie 59 wird anschliessend an der Umlenktrommel 41 umgelenkt und in die Reaktionszone 51 eingeführt.

Von mehreren, bezüglich der Bewegungsrichtung der Werkstoffbahn vor der Doppelbandpresse befindlichen Abwickeleinheiten 60, die ebenso wie die Doppelbandpresse vertikal aufrecht angeordnet sind, werden Bahnen 61 kontinuierlich abgezogen und zwischen den beiden Kupferfolien 59, 69 durch die Doppelbandpresse hindurchgezogen. Diese Bahnen 61 bestehen wiederum aus mit Epoxyharz imprägniertem Glasfasergewebe. Die Anzahl der Abwickeleinheiten 60 richtet sich nach dem gewünschten Aufbau der Kernschicht des Elektrolaminats. In der Reaktionszone 51 werden die Glasfaserbahnen miteinander und den beiden Kupferfolien unter Einwirkung von Wärme zu einem Elektrolaminat 62 verpresst, das in der Zeichnung auf der rechten Seite die Doppelbandpresse 40 kontinuierlich verlässt.

Eine weitere zweckmässige Ausgestaltung des erfindungsgemässen Verfahrens ist in Fig. 3 bei der in Vorlaufrichtung links liegenden Doppelbandeinheit 49 gezeigt. Die Galvanisierung der Kupferfolie 69 auf das Pressband 45 erfolgt dort durch das an sich bekannte Tampon-Verfahren. Eine mit dem positiven Pol der Gleichspannungsquelle verbundene und damit als Anode wirkende Platte 70, die aus Platin besteht, ist mit einem schwammartigen Filzgewebe 71 umhüllt. Dieses Filzgewebe 71 besitzt eine bestimmte Breite, so dass der Abstand der Anode 70 von dem Pressband 45 sehr exakt definiert ist. Das Filzgewebe 71 ist mit der aus Kupfersulfat bestehenden Elektrolytflüssigkeit getränkt. Das Pressband 45 ist wie bereits weiter oben beschrieben wieder als Kathode geschaltet. Da mit Hilfe des Filzgewebes ein sehr kleiner Abstand zwischen Anode 70 und Pressband 45 möglich ist, erhält man hohe Stromdichten und damit hohe Abscheideraten von Kupfer auf der Pressbandoberfläche 45.

Das Filzgewebe 71 dient gleichzeitig als eine Art Gefäss für die Elektrolytflüssigkeit. Damit entfallen vorteilhafterweise aufwendige Abdichtvorrichtungen, die bei dem wannenförmigen Bad 52 nötig sind, um ein Ausfliessen der Elektrolytflüssigkeit zu verhindern. Um Temperatur- und Konzentrationskonstanz der Elektrolytflüssigkeit zu sichern, kann die Elektrolytflüssigkeit auch mit einer Pumpe durch das Filzgewebe 71 ständig durchbewegt werden. Selbstverständlich können auch Elektrolytflussigkeiten verwendet werden, die mit bestimmten Zusätzen versehen sind, um eine verbesserte Abscheidung des Kupfers zu erreichen. Solche Elektrolytflüssigkeiten sind bei der Galvanisierung mittels des Tamponverfahrens an sich bekannt.

Das beschriebene Tamponverfahren kann ebenfalls für die in Fig. 3 in Vorlaufrichtung rechts liegende Doppelbandeinheit verwendet werden. Falls es wünschenswert erscheint, können auch die Vorrichtungen entsprechend den Fig. 1 und 2 anstelle der Wanne mit der Elektrolytflüssigkeit ein solches Filzgewebe 71 erhalten.

**Patentansprüche**

1. Verfahren zur kontinuierlichen Herstellung von kupferkaschierten Laminaten, die aus einem Kern von mehreren Lagen von isolierendem Material und aus auf einer oder beiden Oberflächen des Kerns befindlichen elektrolytisch abgeschiedenen Kupferfolie bzw. Kupferfolien bestehen, wobei die harzimprägnierten Schichtstoffbahnen für den Kern von Vorratsrollen abgewickelt, mit einer bzw. zwei Kupferfolien zu einem Schichtgebilde zusammengeführt und anschließend zwischen zwei mit derselben Geschwindigkeit sich bewegenden endlosen Preßbändern einer Doppelbandpresse so geführt werden, daß die Kupferfolie sowohl an einer Seite des Schichtstoffkerns als auch an einem Preßband anliegt bzw. daß die erste Kupferfolie sowohl an einer Seite des Schichtstoffkerns als auch an einem Preßband und die zweite Kupferfolie sowohl an der anderen Seite des Schichtstoffkerns als auch am anderen Preßband anliegen, dieses Schichtgebilde unter Einwirkung von Hitze und Druck in der zwischen den beiden Preßbändern liegenden Reaktionszone zur kupferkaschierten Laminatbahn ausgehärtet wird, die kupferkaschierte Laminatbahn anschließend in Vorlaufrichtung der Preßbänder hinter der Reaktionszone die Doppelbandpresse verläßt und danach in Platten beliebiger Größe aufgeteilt oder in einer Vorratsrolle aufgewickelt wird, falls es sich um eine flexible Laminatbahn handelt, dadurch gekennzeichnet, daß eine Kupferschicht auf einem Teil eines Preßbandes oder beider Preßbänder, der sich in Vorlaufrichtung der sich kontinuierlich bewegenden Preßbänder vor der Reaktionszone und auf der dem Schichtstoff zugekehrten Seite des Preßbandes bzw. der Preßbänder befindet, galvanisch abgeschieden wird, diese Kupferschicht von dem Preßband bzw. den Preßbändern in die Reaktionszone transportiert wird, diese Kupferschicht in der Reaktionszone dann als Kupferfolie zur Verpressung mit den Schichtstoffbahnen verwendet wird und die Kupferfolie der kupferkaschierten Laminatbahn bei Verlassen der Doppelbandpresse kontinuierlich von den Preßbändern abgelöst wird.

2. Verfahren nach Anspruch 1, dadurch gekennzeichnet, daß die auf dem Preßband abgeschiedene Kupferschicht an ihrer dem Schichtstoffkern zugewandten Seite vor Eintritt in die Reaktionszone zur Verbesserung der Haftfähigkeit auf dem Schichtstoff vorbehandelt wird.

3. Verfahren nach Anspruch 2, dadurch gekennzeichnet, daß auf der dem Schichtstoffkern zugewandten Seite der Kupferschicht eine stark knospenbildende Messingauflage aufgebracht wird.

4. Vorrichtung zur Durchführung des Verfahrens nach Anspruch 1, bestehend aus einer Doppelbandpresse, die zwei endlose, über in einem Pressengestell drehbar gelagerte Umlenktrommeln geführte Preßbänder besitzt, zwischen deren einander gegenüberliegenden Bandtrums die Reaktionszone gebildet wird, mit im Pressengestell angeordneten Druckplatten, von denen der Druck mit hydraulischen oder mechanischen Mitteln in der Reaktionszone auf die Innenseiten der Preßbänder aufgebracht und dort auf das zu verpressende Schichtgebilde übertragen wird, dadurch gekennzeichnet, daß die Doppelbandpresse (1) vertikal aufgestellt wird, so daß die Längsseite der Preßbänder (8, 9) in der Reaktionszone (18) in vertikaler Richtung zeigt, jede Doppelbandeinheit (24, 25) drei Umlenktrommeln (2, 3, 4 bzw. 5, 6, 7) besitzt, um die jeweils ein Preßband (8, 9) geschlungen ist, wobei die Umlenktrommeln (2, 3, 4 bzw. 5, 6, 7) so angeordnet sind, daß sie an den Ecken eines Dreiecks sitzen und zwei Umlenktrommeln (2, 4 bzw. 5, 6) auf der vertikalen Linie liegen, bei mindestens einer Doppelbandeinheit (24, 25) an der Außenseite des Preßbandes (8, 9) entlang der Linie zwischen der unteren Umlenktrommel (2 bzw. 5) der Vertikalen und der der Vertikalen gegenüberliegenden Umlenktrommel (3 bzw. 7) ein galvanisches Bad zur Kupferabscheidung angebracht ist, das aus einem zur Aufnahme von Elektrolyten (14) geeigneten Hohlraum (12 bzw. 13) mit einer Anode (15) besteht, dessen Größe und Lage von der die Kathode bildenden Bandoberfläche bestimmt wird, die Bewegungsrichtung der Preßbänder (8, 9) in Richtung auf die der Vertikalen gegenüberliegenden Umlenktrommel (3 bzw. 7) zu erfolgt und in der Nähe der auf der Vertikalen oben befindlichen Umlenktrommel (4 bzw. 6) Abwickeleinheiten (19a, 19b, 20a, 20b) für die Schichtstoffbahnen (21a, 21b, 22a, 22b) angeordnet sind.

5. Vorrichtung zur Durchführung des Verfahrens nach Anspruch 1, bestehend aus einer Doppelbandpresse, die zwei endlose, über in einem Pressengestell drehbar gelagerte Umlenktrommeln geführte Preßbänder besitzt, zwischen deren einander gegenüberliegenden Bandtrums die Reaktionszone gebildet wird, mit im Pressengestell angeordneten Druckplatten, von denen der Druck mit hydraulischen oder mechanischen Mitteln in der Reaktionszone auf die Innenseiten der Preßbänder aufgebracht und dort auf das zu verpressende Schichtgebilde übertragen wird, dadurch gekennzeichnet, daß die Doppelbandpresse (1) vertikal aufgestellt wird, so daß die Längsseite der Preßbänder (8, 9) in der Reaktionszone (18) in vertikaler Richtung zeigt, jede Doppelbandeinheit (24, 25) drei Umlenktrommeln (2, 3, 4 bzw. 5, 6, 7) besitzt, um die jeweils ein Preßband (8, 9) geschlungen ist, wobei die Umlenktrommeln (2, 3, 4 bzw. 5, 6, 7) so angeordnet sind, daß sie an den Ecken eines Dreiecks sitzen und zwei Umlenktrommeln (2, 4 bzw. 5, 6) auf der vertikalen Linie liegen, bei mindestens einer Doppelbandeinheit (24, 25) an der Außenseite des Preßbandes (8, 9) entlang der Linie zwischen der unteren Umlenktrommel (2 bzw. 5) der Vertikalen und der der Vertikalen gegenüberliegenden Umlenktrommel (3, bzw. 7) ein galvanisches Bad zur Kupferabscheidung angebracht ist, das aus einem zur Aufnahme von Elektrolyten (14) geeigneten Hohlraum (12 bzw. 13) mit einer Anode (15) besteht, dessen Größe und Lage von der die Kathode bildenden Bandoberfläche bestimmt wird, die Bewegungsrichtung der Preßbänder (8, 9) in Richtung von der der Vertikalen gegenüberliegenden Umlenktrommel (3 bzw. 7) weg erfolgt und in der Nähe der auf der Vertikalen unten befindlichen Umlenktrommel (2 bzw. 5) Abwickeleinheiten (35a, b, c, d) für die Schichtstoffbahnen (21a, 21b, 22a, 22b) angeordnet sind.

6. Vorrichtung zur Durchführung des Verfahrens nach Anspruch 1, bestehend aus einer Doppelbandpresse, die zwei endlose, über in einem Pressengestell drehbar gelagerte Umlenktrommeln geführte Preßbänder besitzt, zwischen deren einander gegenüberliegenden Bandtrums die Reaktionszone gebildet wird, mit im Pressengestell angeordneten Druckplatten, von denen der Druck mit hydraulischen oder mechanischen Mitteln in der Reaktionszone auf die Innenseiten der Preßbänder aufgebracht und dort auf das zu verpressende Schichtgebilde übertragen wird, dadurch gekennzeichnet, daß die je zwei Umlenktrommeln (41, 42 bzw. 43, 44) mit einem Preßband (45 bzw. 46) enthaltenden zwei Doppelbandeinheiten (49, 50) einer an sich bekannten Doppelbandpresse (40) hochkant so aufgestellt sind, daß die Breitseite der Preßbänder (45, 46) in vertikaler Richtung zeigt, bei mindestens einer Doppelbandeinheit (49 bzw. 50) an der der Reaktionszone (51) abgewandten Seite auf der Außenseite des Preßbandes (45 bzw. 46) ein galvanisches Bad zur Kupferabscheidung angebracht ist, das aus einem zur Aufnahme von Elektrolyten (54) geeigneten Hohlraum (52, 71) mit einer Anode (70) besteht, dessen Größe und Lage von der die Kathode bildenden Bandoberfläche bestimmt wird und in der Nähe der in Bezug auf die Bewegungsrichtung der Preßbänder (45, 46) zur Reaktionszone (51) einlaufseitigen Umlenktrommel (41 bzw. 44) hochkant gestellte Abwickeleinheiten (60) für die Schichtstoffbahnen (61) angeordnet sind.

7. Vorrichtung nach Ansprüche 4 oder 5, dadurch gekennzeichnet, daß die Linie von der unteren Umlenktrommel (2 bzw. 5) zu der der Vertikalen gegenüberliegenden Umlenktrommel (3 bzw. 7) horizontal verläuft, so daß diese Linie mit der Vertikalen einen rechten Winkel einschließt.

8. Vorrichtung nach einem der Ansprüche 4 bis 6, dadurch gekennzeichnet, daß die Anode (15, 70) aus einem gegenüber der Elektrolytflüssigkeit (14, 54) inertem Metall besteht und die Elektrolytflüssigkeit (14, 54) das abzuscheidende Kupfer bereits als Ion enthält.

9. Vorrichtung nach Anspruch 8, dadurch gekennzeichnet, daß sowohl die Konzentration als auch die Temperatur der Elektrolytflüssigkeit (14, 54) durch Zufuhr von frischem Elektrolyten konstant gehalten wird.

10. Vorrichtung nach Anspruch 8, dadurch gekennzeichnet, daß die Anode (15, 70) aus Blei besteht.

11. Vorrichtung nach Anspruch 8, dadurch gekennzeichnet, daß die Anode (15, 70) aus Platin besteht.

12. Vorrichtung nach Anspruch 8, dadurch gekennzeichnet, daß die Elektrolytflüssigkeit (14, 54) aus Kupfersulfatlösung besteht.

13. Vorrichtung nach einem der Ansprüche 4 bis 6, dadurch gekennzeichnet, daß die Anode (15) mindestens teilweise aus Kupfer besteht.

14. Vorrichtung nach mindestens einem der Ansprüche 4 bis 13, dadurch gekennzeichnet, daß die Anode (15, 70) plattenförmig ausgebildet ist und über die gesamte Fläche denselben Abstand zur Preßbandaußenseite besitzt.

15. Vorrichtung nach mindestens einem der Ansprüche 4 bis 14, dadurch gekennzeichnet, daß der den Elektrolyten (14, 54) aufnehmende Hohlraum als Wanne (12, 52) ausgebildet ist, deren dem Preßband (8, 9 bzw. 45, 46) zugewandte Ränder mittels Dichtungen (53) gegen den Austritt der Elektrolytflüssigkeit (14, 54) abgedichtet sind.

16. Vorrichtung nach Anspruch 15, dadurch gekennzeichnet, daß die Wanne (52) aus einem gegenüber der Elektrolytflüssigkeit (54) inertem Metall besteht und als Anode geschaltet ist.

17. Vorrichtung nach mindestens einem der Ansprüche 4 bis 14, dadurch gekennzeichnet, daß der den Elektrolyten aufnehmende Hohlraum aus einem die Anode (70) umhüllenden filzartigen Tampon (71) besteht, in dessen Poren sich die das abzuscheidende Kupfer als Ion enthaltende Elektrolytflüssigkeit befindet.

18. Vorrichtung nach mindestens einem der Ansprüche 4 bis 17, dadurch gekennzeichnet, daß bei dem die Kathode bildenden Teil des Preßbandes (8, 9 bzw. 45, 46) im geringen Abstand zur Preßbandinnenseite eine metallische Platte (16, 55) angebracht ist, die mit dem negativen Pol der Spannungsquelle verbunden ist und die Stromzuführung von der Platte (16, 55) auf das Preßband (8, 9 bzw. 45, 46) durch eine in dem Spalt zwischen Preßbandinnenseite und Platte (16, 55) befindliche metallische Flüssigkeit (81) erfolgt.

19. Vorrichtung nach Anspruch 18, dadurch gekennzeichnet, daß als metallische Flüssigkeit (81) Quecksilber verwendet wird.

20. Vorrichtung nach den Ansprüchen 18 und 19, dadurch gekennzeichnet, daß der Rand des Spaltes zwischen der Platte (16, 55) und der Preßbandinnenseite mittels Dichtungen (80) abgedichtet ist.

21. Vorrichtung nach mindestens einem der Ansprüche 4 bis 17, dadurch gekennzeichnet, daß bei dem die Kathode bildenden Teil des Preßbandes (46) im geringen Abstand zur Preßbandinnenseite eine Stützplatte (55) angebracht ist, die mit dem negativen Pol der Spannungsquelle verbunden ist und die Stromzuführung von der Stützplatte (55) auf das Preßband (46) durch nebeneinanderliegende Gleitleisten (56) aus Metall erfolgt, die mit der Stützplatte (55) leitend verbunden sind und das Preßband (46) gleitend berühren.

## Claims

1. Method for the continuous production of copper-clad laminates, which consist of a core of several layers of insulating material and of an electrolytically precipitated copper foil or foils disposed on one or both surfaces of the core, wherein the resin-impregnated layered substance webs for the core are unreeled from stock rolls, brought together with one or two copper foils into a layer formation and subsequently so guided between two endless press bands of a double band press, which are moving at the same speed, that either the copper foil lies against one side of the layered substance core as well as against a press band or the first copper foil lies against one side of the layered substance core as well as against a press band and the second copper foil lies against the other side of the layered substance core as well as against the other press band, this layer formation is set into the copper-clad laminate web under the influence of heat and pressure in the reaction zone lying between both the press bands, the copper-clad laminate web subsequently leaves the double band press behind the reaction zone in advancing direction of the press bands and is thereafter either divided up into plates of desired size or reeled into a stock roll in case a flexible laminate web is concerned, characterised thereby, that a copper layer is electroplated onto a part of a press band or of both press bands, which part is situated in front of the reaction zone in the direction of advance of the continuously moving press bands and on that side of the press band or bands, which faces the layered substance, this copper layer is transported by the press band or bands into the reaction zone, this copper layer is then used in the reaction zone as copper foil for pressing together with the layered substance webs and the copper foil of the copper-clad laminate web is continuously detached from the press bands on leaving the double band press.

2. Method according to claim 1, characterised thereby, that the copper layer precipitated on the press band is preliminarily treated at its side facing the layered substance core before entry into the reaction zone for better adhesion on the layered substance.

3. Method according to claim 2, characterised thereby, that a strongly bud-forming brass coating is applied onto that side of the copper layer, which faces the layered substance core.

4. Apparatus for the performance of the method according to claim 1 and consisting of a double band press which possesses two endless press bands, which are guided over deflecting drums rotatably borne in a press frame and between the oppositely disposed band runs of which the reaction zone is formed, with pressure plates arranged in the press frame, by which plates the pressure is applied in the reaction zone onto the inward sides of the press bands by hydraulic or mechanical means and there transmitted onto the layer formation to be compressed, characterised thereby, that the double band press (1) is set up vertically so that the longitudinal side of the press bands (8, 9) points in vertical direction in the reaction zone (18), each double band unit (24, 25) possesses three deflecting drums (2, 3, 4 or 5, 6 7), around each of which a respective press band (8, 9) is looped, wherein the deflecting drums (2, 3, 4 or 5, 6, 7) are so arranged that they sit at the corners of a triangle and two deflecting drums (2, 4 or 5, 6) lie on the vertical line, an electroplating bath for copper precipitation is mounted at at least one double band unit (24, 25) at the outward side of the press band (8, 9) along the line between the lower deflecting drum (2 or 5) of the vertical and the deflecting drum (3 or 7) lying opposite the vertical and consists of a hollow space (12 or 13), which is suitable for the reception of electrolytes (14), with at anode (15), the size and position of which is determined by the band surface forming the cathode, the direction of movement of the press bands (8, 9) takes place in the direction of the deflecting drum (3 or 7) lying opposite the vertical and unreeling units (19a, 19b, 20a, 20b) for the layered substance webs (21a, 21b, 22a, 22b) are arranged in the proximity of the deflecting drum (4 or 6) situated above on the vertical.

5. Apparatus for the performance of the method according to claim 1 and consisting of a double band press which possesses two endless press bands, which are guided over deflecting drums rotatably borne in a press frame and between the oppositely disposed band runs of which the reaction zone is formed, with pressure plates arranged in the press frame, by which plates the pressure is applied in the reaction zone onto the inward sides of the press bands by hydraulic or mechanical means and there transmitted onto the layer formation to be compressed, characterised thereby, that the double band press (1) is set up vertically so that the longitudinal side of the press bands (8, 9) points in vertical direction in the reaction zone (18), each double band unit (24, 25) possesses three deflecting drums (2, 3,4 or 5, 6, 7), around each of which a respective press band (8, 9) is looped, wherein the deflecting drums (2, 3, 4 or 5, 6, 7) are so arranged that they sit at the corners of a triangle and two deflecting drums (2, 4 or 5, 6) lie on the vertical line, an electroplating bath for copper precipitation is mounted at at least one double band unit (24, 25) at the outward side of the press band (8, 9) along the line between the lower deflecting drum (2 or 5) of the vertical and the deflecting drum (3 or 7) lying opposite the vertical and consists of a hollow space (12 or 13), which is suitable for the reception of electrolytes (14), with an anode (15), the size and position of which is determined by the band surface forming the cathode, the direction of movement of the press bands (8, 9) takes place in the direction away from the deflecting drum (3 or (3 or 7) lying opposite the vertical and unreeling units (35a, b, c, d) the layered substance webs (21 a, 21b, 22a, 22b) are arranged in the proximity of the deflecting drum (2 or 5) situated below on the vertical.

6. Apparatus for the performance of the method according to claim 1 and consisting of a double band press which possesses two endless press bands, which are guided over deflecting drums rotatably borne in a press frame and between the oppositely disposed band runs of which the reaction zone is formed, with pressure plates arranged in the press frame, by which plates the pressure is applied in the reaction zone onto the inward sides of the press bands by hydraulic or mechanical means and there transmitted onto the layer formation to be compressed, characterised thereby, that the two double band units (49, 50), which each contain two deflecting drums (41, 42 or 43, 44) with a press band (45 or 46), of an in itself known double band press (40) are so set up upright that the wide side of the press belts (45, 46) points in vertical direction, an electroplating bath for copper precipitation is mounted at at least one double band unit (49 or 50) at that side on the outward side of the press band (45 or 46), which is remote from the reaction zone (51), and consists of a hollow space (52, 71), which is suitable for the reception of electrolytes (54), with an anode (70), the size and position of which is determined by the band surface forming the cathode, and unreeling units (60), set upright, for the layered substance webs (61) are arranged in the proximity of the deflecting drum (41 or 44) at the inlet side with respect to the direction of movement of the press bands (45, 46) to the reaction zone (51).

7. Apparatus according to claim 4 or 5, characterised thereby, that the line from the lower deflecting drum (2 or 5) to the deflecting drum (3 or 7) lying opposite the vertical extends horizontally so that this line includes a right angle with the vertical.

8. Apparatus according to one of the claims 4 to 6, characterised thereby, that the anode (15, 70) consists of a metal which is inert to the electrolyte liquid (14, 54) and the electrolyte liquid (14, 54) contains the copper to be precipitated already as ion.

9. Apparatus according to claim 8, characterised thereby, that the concentration as well as also the temperature of the electrolyte liquid (14, 54) are kept constant by supply of a fresh electrolyte.

10. Apparatus according to claim 8, characterised thereby, that the anode (15, 70) consists of lead.

11. Apparatus according to claim 8, characterised thereby, that the anode (15, 70) consists of platinum.

12. Apparatus according to claim 8, characterised thereby, that the electrolyte liquid (14, 54) consists of copper sulphate solution.

13. Apparatus according to one of the claims 4 to 6, characterised thereby, that the anode (15) consists at least partially of copper.

14. Apparatus according to at least one of the claims 4 to 13, characterised thereby, that the anode (15, 70) is constructed to be plate-shaped and over the entire area possesses the same spacing from the outward side of the press band.

15. Apparatus according to at least one of the claims 4 to 14, characterised thereby, that the hollow space receiving the electrolyte (14, 54) is constructed as trough (12, 52), the rims of which facing the press band (8, 9 or 45, 46) are sealed by means of seals (53) against the exit of the electrolyte liquid (14, 54).

16. Apparatus according to claim 15, characterised thereby, that the trough (52) consists of a metal which is inert to the electrolyte liquid (54) and is connected as anode.

17. Apparatus according to at least one of the claims 4 to 14, characterised thereby, that the hollow space receiving the electrolyte consists of a feltlike pad (71), which envelopes the anode (70) and in the pores of which is disposed the electrolyte liquid containing the copper to be precipitated as ion.

18. Apparatus according to at least one of the claims 4 to 17, characterised thereby, that a metallic plate (16, 55) is mounted at a small spacing from the inward side of the press band in that part of the press band (8, 9 or 45, 46), which forms the cathode, and is connected with the negative pole of the voltage source and the current supply from the plate (16, 55) to the press band (8, 9 or 45, 46) takes place through a metallic liquid (81) disposed in the gap between the inward side of the press band and the plate (16, 55).

19. Apparatus according to claim 18, characterised thereby, that mercury is used as metallic liquid (81).

20. Apparatus according to the claims 18 and 19, characterised thereby, that the rim of the gap between the inward side of the press band and the plate (16, 55) is sealed off by means of seals (80).

21. Apparatus according to at least one of the claims 4 to 17, characterised thereby, that a support plate (55) is mounted at a small spacing from the inward side of the press band in that part of the press band (46), which forms the cathode, and is connected with the negative pole of the voltage source and the current supply from the support plate (55) to the press band (46) takes place through sliding strips (56) of metal, which lie one beside the other, are conductively connected with the support plate (55) and slidingly touch the press band (46).

## Revendications

1. Procédé en continu pour la fabrication de laminés revêtus de cuivre, qui se composent d'un noyau formé de plusieurs couches de matériau isolant et d'une feuille de cuivre, respectivement de feuilles de cuivre déposée(s) électrolytiquement sur une ou plusieurs surfaces du noyau, les bandes de stratifié préimprégné pour le noyau étant à cette occasion déroulées de rouleaux de stockage, réunis à une, respectivement deux feuilles de cuivre entre deux bandes de pressage d'une presse à double bande, se déplaçant à la même vitesse, de sorte que la feuille de cuivre appuie aussi bien sur un côté du noyau stratifié qu'également sur une bande de pressage, respectivement également sur une bande de pressage et que la deuxième feuille de cuivre appuie aussi bien sur l'autre côté du noyau stratifié qu'également sur l'autre bande de pressage, ce produit stratifié étant durci sous l'effet de la chaleur et de la pression dans la zone de réaction située entre les deux bandes de pressage, pour former une bande de laminé revêtue de cuivre, la bande de laminé revêtue de cuivre quittant immédiatement après la presse à double bande, derrière la zone de réaction, dans le sens de déplacement des bandes de pressage, et étant ensuite divisée en plaques de la taille voulue ou enroulées sur un rouleau de stockage, pour le cas où il s'agit d'une bande de laminé flexible, caractérisé en ce qu'une couche de cuivre est déposée galvaniquement sur une partie d'une bande de pressage ou des deux bandes de pressage, des bandes de pressage se déplaçant en continu devant la zone de réaction dans le sens d'avancement et qui se trouve sur le côté de la bande de pressage, respectivement des bandes de pressage, qui est tourné vers le produit stratifié, cette couche de cuivre étant transportée dans la zone de réaction par la bande de pressage, respectivement par les bandes de pressage, cette couche de cuivre située dans la zone de réaction étant ensuite utilisée comme feuille de cuivre pour être pressée avec les bandes de produit stratifié et la feuille de cuivre de la bande de laminé recouverte de cuivre étant détachée des bandes de pressage en continu lorsqu'elle quitte la presse à double bande.

2. Procédé selon la revendication 1, caractérisé en ce que la couche de cuivre déposée sur la bande de pressage est prétraitée sur son côté tourné vers le noyau de stratifié, avant l'entrée dans la zone de réaction pour améliorer l'adhérence sur le matériau stratifié.

3. Procédé selon la revendication 2, caractérisé en ce qu'un dépôt de laiton formant de fortes pointes est appliqué sur le côté de la couche de cuivre qui est tournée vers le noyau de produit stratifié.

4. Dispositif pour l'exécution du procédé selon la revendication 1, se composant d'une presse à double bande, qui possède deux bandes de pressage sans fin guidées sur des tambours de renvoi montés tournant dans un bâti de presse, tambours entre les tronçons de bande opposés desquels est formée la zone de réaction, avec des plaques de pression disposées dans le bâti de presse, à partir desquelles la pression est appliquée dans la zone de réaction avec des moyens hydrauliques ou mécaniques, sur le côté intérieur des bandes de pressage, et y est transmis sur le produit stratifié, caractérisé en ce que la presse à double bande (1) est montée verticalement, de sorte que le côté longitudinal des bandes de pressage (8, 9), dans la zone de réaction (18), soit en direction verticale, chaque unité de double bande (24, 25) possède trois tambours de renvoi (2, 3, 4, respectivement 5, 6, 7) autour desquels est chaque fois enroulée une bande de pressage (8, 9), les tambours de renvoi étant à cette occasion disposés de telle manière qu'ils sont aux coins d'un triangle et que deux tambours de renvoi (2, 4, respectivement 5, 6) sont sur la ligne verticale, dans le cas au moins d'une unité à double bande (24, 25) sur le côté extérieur de la bande de pressage (8, 9) le long de la ligne située entre le tambour de renvoi inférieur (2 respectivement 5) de la verticale et du tambour de renvoi (3 respectivement 7) opposé à la vertical, il est monté un bain galvanique pour le dépôt du cuivre, qui se compose d'une enceinte creuse (12 respectivement 13) appropriée pour recevoir un électrolyte (14) avec une anode (15), dont la taille et la position est déterminée par la surface de bande formant cathode, le sens de déplacement des bandes de pressage (8, 9) s'effectue en direction du tambour de renvoi (3, respectivement 7) opposé à la verticale, et des unités de déroulement (19a, 19b, 20a, 20b), pour les bandes de produit stratifié (21a, 21b, 22a, 22b), sont disposées au voisinage du tambour de renvoi (4, respectivement 6) se trouvant verticalement au-dessus.

5. Dispositif pour l'exécution du procédé selon la revendication 1, se composant d'une presse à double bande qui possède deux bandes sans fin guidées sur des tambours de renvoi montés tournants dans un bâti de presse, entre les tronçons de bande opposés desquels est formée la zone de réaction, avec des plaques de pression disposées dans le bâti de presse, à partir desquelles la pression est appliquée dans la zone de réaction avec des moyens hydrauliques ou mécaniques sur le côté intérieur des bandes de pressage et y est transmise sur le produit stratifié à presser, caractérisé en ce que la presse à double bande (1) est montée verticale, de telle sorte que le côté longitudinal des bandes de pressage (8, 9) situé dans la zone de réaction (18) soit en direction verticale, chaque unité de double bande (24, 25) possède trois tambours de renvoi (2, 3, 4 respectivement 5, 6, 7), autour desquels est enroulée chaque fois une bande de pressage (8, 9), les tambours de renvoi (2, 3, 4, respectivement 5, 6, 7) étant à cette occasion disposés de telle sorte qu'ils sont aux coins d'un triangle et que deux tambours de renvoi (2, 4, respectivement 5, 6) sont situés sur la ligne verticale, qu'un bain galvanique pour le dépôt de cuivre est monté sur au moins une unité à double bande (24, 25), sur le côté extérieur de la bande de pressage (8, 9), le long de la ligne située entre le tambour de renvoi inférieur (2 respectivement 5) de la verticale et le tambour de renvoi (3 respectivement 7) opposé à la verticale, bain qui se compose d'une enceinte creuse (12, respectivement 13) appropriée pour recevoir des électrolytes (14), avec une anode (15), dont la taille et la position est déterminé par la surface de bande formant la cathode, le sens de déplacement des bandes de pressage (8, 9) s'effectuant en direction du tambour de renvoi (3, respectivement 7) opposé à la verticale et des unités de déroulement (35a, b, c, d) pour la bande de matériau stratifié (21a, 21b, 22a, 22b) étant disposées au voisinage du tambour de renvoi se trouvant audessous, sur la verticale.

6. Dispositif pour l'exécution du procédé selon la revendication 1, se composant d'une presse à double bande, qui possède deux bandes de pressage sans fin guidées sur les tambours de renvoi montés tournants sur un bâti de presse, entre les tronçons de bande opposés desquels est formée la zone de réaction, avec des plaques de pression disposées dans le bâti de presse, à partir desquelles la pression est appliquée dans la zone de réaction avec des moyens hydrauliques ou mécaniques sur le côté intérieur des bandes de pressage et y est transmise sur le produit stratifié à presser, caractérisé en ce que deux unités à double bande (49, 50) d'une presse à double bande (40) connue en soi, contenant les deux tambours de renvoi (41, 42 respectivement 43, 44) avec une bande de pressage (45, respectivement 46) sont montés debout, en ce que le côté large des bandes de pressage (45, 46) en direction verticale présente un bain galvanique de dépôt de cuivre, sur au moins une unité de double bande (49 respectivement 50) sur le côté opposé à la zone de réaction (51), sur le côté extérieur de la bande de pressage (45, 46), bain qui se compose d'une enceinte creuse (52, 71) appropriée à recevoir des électrolytes (54), avec une anode (70) dont la taille et la position sont déterminées par la surface de bande formant la cathode et des unités de déroulement (60) pour les bandes de produit stratifié (61) étant disposées au voisinage des tambours de renvoi (41, respectivement 44) situés à l'entrée, relativement au sens de déplacement des bandes de pressage (45, 46) par rapport à la zone de réaction (51).

7. Dispositif selon les revendications 5 ou 6, caractérisé en ce que la ligne allant du tambour de renvoi inférieur (2 respectivement 5) au tambour de renvoi opposé sur la verticale (3 respectivement 7) se développe horizontalement, de sorte que cette ligne fait un angle droit avec la verticale.

8. Dispositif selon l'une des revendications 4 à 6, caractérisé en ce que l'anode (15, 70) se compose d'un métal inerte par rapport au liquide d'électrolyte (14, 54) et que le liquide d'électrolyte (14, 54) contient déjà le cuivre à déposer sous forme d'ion.

9. Dispositif selon la revendication 8, caractérisé en ce qu'aussi bien la concentration que la température du liquide électrolyte (14, 54) sont maintenues constantes par amenée d'électrolyte frais.

10. Dispositif selon la revendication 8, caractérisé en ce que l'anode (15, 70) se compose de plomb.

11. Dispositif selon la revendication 8, caractérisé en ce que l'anode (15, 70) se compose de platine.

12. Dispositif selon la revendication 8, caractérisé en ce que le liquide d'électrolyte se compose de solution de sulfate de cuivre.

13. Dispositif selon l'une des revendications 4 à 6, caractérisé en ce que l'anode (15) se compose au moins partiellement de cuivre.

14. Dispositif selon l'une des revendications 4 à 13, caractérisé en ce que l'anode (15, 70) est réalisée sous forme de plaque et possède sur toute sa surface le même écartement par rapport au côté extérieur de bande de pressage.

15. Dispositif selon l'une des revendications 4 à 14, caractérisé en ce que l'enceinte creuse recevant l'électrolyte (14, 54) est réalisée sous forme de bac (12, 52) dont les bords tournés vers la bande de pressage (8, 9 respectivement 45, 46) sont isolés de manière étanche contre la sortie du liquide électrolyte (14, 54).

16. Dispositif selon la revendication 15, caractérisé en ce que le bac (52) se compose d'un matériau inerte vis-à-vis du liquide d'électrolyte (54) et est branché en anode.

17. Dispositif selon au moins l'une des revendications 4 à 14, caractérisé en ce que l'enceinte creuse recevant l'électrolyte se compose d'un tampon (71) fibreux entourant l'anode, dans les pores duquel se trouve le cuivre à déposer, sous forme de liquide électrolyte contenant le cuivre à déposer sous forme d' ion.

18. Dispositif selon au moins l'une des revendications 4 à 17, caractérisé en ce qu'une plaque (16, 55) métallique est montée à faible distance du côté intérieur de la bande de pressage, dans la partie de la bande de pressage (8, 9 respectivement 45, 46) formant l'anode, plaque qui est reliée au pôle négatif de la source de tension et que l'amenée de courant s'effectue par la plaque (16, 55) sur la bande de pressage (8, 9 respectivement 45, 46) au moyen d'un liquide (81) métallique se trouvant dans l'interstice situé entre côté intérieur de bande de pressage et plaque (16, 55)

19. Dispositif selon la revendication 18, caractérisé en ce que du mercure est utilisé pour le liquide (81) métallique.

20. Dispositif selon les revendications 18 et 19, caractérisé en ce que le bord de l'interstice entre plaque (16, 55) et côté intérieur de bande de pressage est isolé de manière étanche au moyen d'étanchéités (80).

21. Dispositif selon au moins l'une des revendications 4 à 17, caractérisé en ce que dans la partie de la bande de pressage (46) formant la cathode, une plaque d'appui (55) est montée à faible distance du côté intérieur de bande de pressage, plaque qui est reliée au pôle négatif de la source de tension et que l'amenée de courant depuis la plaque d'appui (56) sur la bande de pressage (46) s'effectue au moyen de bandes de glissement (56) en métal situées les unes à côté des autres, bandes qui sont reliées conductrices à la plaque d'appui (55) et qui touchent en glissant la bande de pressage (46).

Fig. 1

Fig. 2

Fig. 3

Fig. 4